# EUROPÄISCHE PATENTANMELDUNG

(11) **EP 1 296 153 A1**
(43) Veröffentlichungstag der Anmeldung: **26.03.2003**
(21) Anmeldenummer: 01122774.1
(22) Anmeldetag: 21.09.2001
(51) Int. Cl.: G01R 31/3185

(54) **Elektronischer Baustein**

(71) Anmelder: SIEMENS AKTIENGESELLSCHAFT, 80333 München (DE)
(72) Erfinder: Ghameshlu, Majid, 1110 Wien (AT); Krause, Karlheinz, 82152 Planegg (DE)

(57) **Zusammenfassung**

Um bei einem Elektronischen Baustein (10) mit einer Integrierten Schaltung, die einen Core mit funktionalen Flip-Flops aufweist, wobei ein Teil der funktionalen Flip-Flops als Input-FFs (18) mit Eingangspins (19) des Bausteins (10) und ein Teil der funktionalen Flip-Flops als Output-FFs (23) mit Ausgangspins (27) des Bausteins (10) verbunden sind, hohe Timing-Anforderungen zu erfüllen, dabei jedoch nicht die Timing- und Logik-Verifikation zu erschweren, werden die Input-FFs (18) und die Output-FFs (23) so angeordnet, daß sie jeweils mindestens einen Eingabeblock (11) und einen Ausgabeblock (13) mit eigenen Taktdomänen, die sich von der Taktdomäne des Restcores (12) unterscheiden, bilden.

## Beschreibung

Die Erfindung bezieht sich auf einen elektronischen Baustein mit einer Integrierten Schaltung, die einen Core mit funktionalen Flip-Flops aufweist, wobei ein Teil der funktionalen Flip-Flops als Input-FFs mit Eingangspins des Bausteins und ein Teil der funktionalen Flip-Flops als Output-FFs mit Ausgangspins des Bausteins verbunden sind.

Elektrische Bausteine dieser Art werden häufig als Application Specific Integrated Circuit (ASIC) ausgebildet. Als ASIC bezeichnet man eine Anordnung von logischen Gatter- sowie Speicherschaltungen auf einem einzelnen Siliziumwafer. ASICs sind eine Ansammlung von Schaltungen mit einfachen Funktionen, wie Flip-Flops, Invertierern, NANDs und NORs, sowie von komplexeren Strukturen wie Speicheranordnungen, Addierern, Zählern und Phasenregelschleifen. Die verschiedenen Schaltungen werden in einem ASIC kombiniert, um eine bestimmte Anwendung durchzuführen. Hierbei werden ASICs in einer Vielzahl von Produkten, wie zum Beispiel Konsumprodukten, wie Videospielen, digitale Kameras, in Fahrzeugen und PCs, sowie in High-End Technologie Produkten, wie Workstations und Supercomputern eingesetzt.

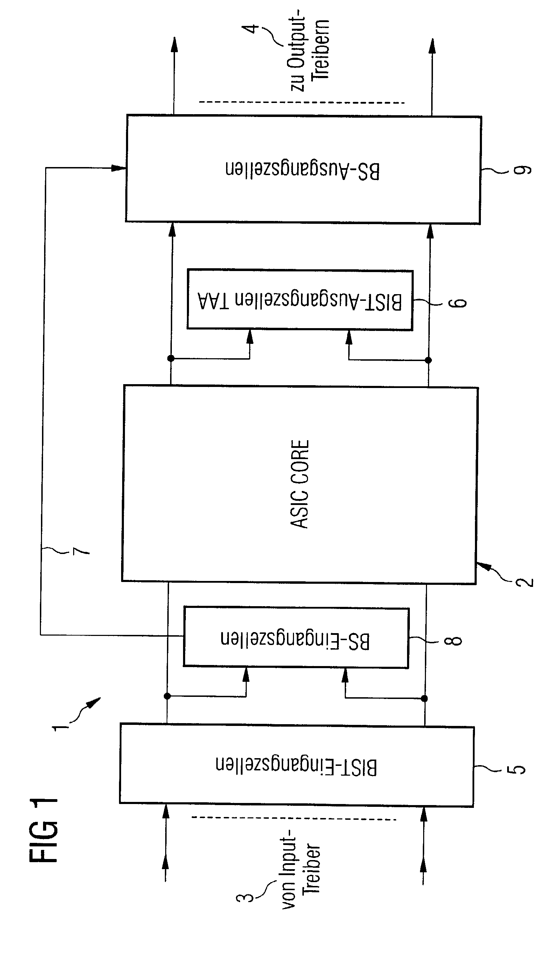

Bezugnehmend auf Figur 1 wird eine bekannte ASIC-Architektur dargestellt. Der ASIC 1 umfaßt einen ASIC-Core 2, in dem die verschiedenen Schaltungselemente, die die Funktion des ASICs 1 bilden, aufgenommen sind. Der ASIC-Core 2 erhält die zu verarbeitenden Eingaben von Input-Treibern 3. Nach der Verarbeitung durch den ASIC-Core 2 werden die Ausgabedaten über Output-Treiber 4 ausgegeben.

Um die Funktionalität des ASICs zu überprüfen, sind verschiedene "Design for test" (DFT) - Verfahren bekannt. Der Vorteil von DFT-Verfahren liegt darin, daß bereits bei der Konstruktion des Chips Schaltungselemente eingefügt werden, die ein späteres scan-basiertes Testen ermöglichen, die Anzahl der benötigten Testpunkte auf dem Board des ASICs reduzieren und zugleich das Problem von nicht vorhandenen Zugriffspunkten auf dem Chip umgehen.

Eines dieser Verfahren ist der "Built-In-Self-Test" (BIST), für den BIST-Eingangs-Zellen 5 zwischen den Input-Treibern 3 und dem ASIC-Core 2 sowie BIST-Ausgangszellen 6, die sich zwischen dem ASIC-Core 2 und den Ausgabe-Treibern 4 befinden, vorgesehen werden. Über die BIST-Eingangszellen kann ein Testvektor in den ASIC-Core 2 eingegeben werden, um die Schaltungen innerhalb des Cores entlang eines "Scanpaths" zu testen. Die Ausgaben des durch den Testvektor stimulierten ASIC-Cores 2 gelangen in die BIST-Ausgangszellen 6, die den Testantwort-Auswerter (TAA) für das BIST-Verfahren darstellen.

Ein weiteres DFT-Verfahren ist der sogenannte Boundary Scan (BS), der auf dem IEEE-Standard 1149-1 basiert und zum Beispiel im Detail in dem Buch "Boundary Scan Test: A Practical Approach", H. Bleeker, Klower Achademic Publishers 1993, ISBN 0-7923-9296-5 beschrieben wird. Der Boundary Scan sieht BS-Eingangszellen 8, die sich zwischen den Input-Treibern 3 und dem ASIC-Core 2 befinden, sowie BS-Ausgangszellen 9 zwischen dem ASIC-Core 2 und den Output-Treibern 4 vor, wobei die Zellen 8, 9 über Verbindung 7 verbunden sind. Das Ziel des Boundary Scans ist der Test von Verbindungen und Anschlüssen zwischen einzelnen Integrierte Schaltungen (ICs). Bei diesem Test bilden die BS-Eingangszellen 8 und die BIST-Ausgangszellen 6 Schieberegister um die Ausgangspins des ASICs zu steuern, und um Eingangspins des ASICs zu testen.

Die zunehmend strenger werdenden Timing-Anforderungen an die ASICs können heutzutage nur durch spezielle Maßnahmen, wie zum Beispiel durch den Einsatz von Phase-Lock-Loops (PLLs) und Taktinseln innerhalb des ASIC-Cores bei der ASIC-Entwicklung erfüllt werden. Durch Schaffung unterschiedlicher Taktinseln ergeben sich im ASIC-Core 1 zusätzliche Schnittstellen, die bezüglich der Timing- und Logik-Verifikation einen weiteren Aufwand sowie zusätzliche Fehlerquellen bilden.

Der vorliegenden Erfindung liegt daher die Aufgabe zugrunde, einen elektronischen Baustein vorzusehen, der die hohen Timing-Anforderungen erfüllt, jedoch nicht die Timing- und Logik-Verifikation erschwert.

Diese Aufgabe wird durch ein elektrisches Bauteil gemäß Anspruch 1 gelöst, bei dem die Input-FFs und die Output-FFs jeweils mindestens einen Eingabeblock und einen Ausgabeblock mit eigenen Taktdomänen, die sich von der Taktdomäne des Restcores unterscheiden, bilden.

Dadurch wird das kritische Input/Output-Timing vom Core-Timing isoliert, und die Input/Output-Timing-Probleme durch die Bildung von Taktdomänen einfacher lokalisierbar, abgrenzbarer, sowie beherrschbarer und überschaubarer.

Gemäß eines vorteilhaften Aspektes der vorliegenden Erfindung werden zur Durchführung eines Boundary Scans (BS) entsprechende BS-Eingangszellen, die den Input-FFs parallel vorgelagert sind, außerhalb des Eingabeblocks und weitere BS-Ausgangszellen nach den Output-FFs außerhalb des Ausgabeblocks vorgesehen sind, um so den Boundary Scan gemäß dem IEEE-Standard 1149-1 zu implementieren.

Gemäß eines weiteren vorteilhaften Ausführungsbeispiels der vorliegenden Erfindung sind zur Durchführung eines Build-In-Self-Tests (BIST) die Input-FFs des Eingabeblocks zu einer Kette zusammenschaltbar (deshalb sind die Input-FF als Scan-FF ausgeführt), und werden während des BIST von einem Testmustergenerator mit Testvektoren gespeist, und weiter werden die Output-FFs des Ausgabeblocks zu einem Linear-Feedback-Shift-Register zusammengeschaltet und bilden einen Testantwortauswerter (TAA) für den BIST. Bei dem vorliegenden Ausführungsbeispiel wird so der BIST ohne Vorsehen von separaten BIST-Eingangs- und Ausgangszellen implementiert, wodurch die Gatterzahl sinkt. Ausgangsseitig wird das Timing auch entschärft, da die Abzapfung für die BIST-Ausgangszellen wegfällt.

Weiterhin fällt eingangsseitig der ansonsten nötige BIST-Multiplexer weg, so daß das Timing des Signal-Input-Pfades verbessert wird.

Gemäß eines anderen vorteilhaften Ausführungsbeispiels der vorliegenden Erfindung unterscheiden sich die Taktphasen der Taktdomänen der Input-FFs und der Output-FFs von der Taktphase des verbleibenden Cores. Dadurch wird die Anordnung der zeitkritischen "ersten" bzw. "letzten" Flip-Flops, also der Input-FFs und der Output-FFs im Baustein-Layout einfacher, da sich alle im Eingabeblock oder Ausgabeblock befinden und diese in der Architektur des erfindungsgemäßen Bausteins eine eigene Einheit bilden.

Gemäß eines anderen vorteilhaften Ausführungsbeispiels der vorliegenden Erfindung unterscheiden sich die Taktphasen der Taktdomänen der Input-FFs und der Output-FFs von der Taktphase einer Systemtaktung des Bausteines, wodurch ebenfalls eine einfachere Anordnung der Elemente im Layout ermöglicht wird.

Gemäß eines besonders vorteilhaften Ausführungsbeispiels der vorliegenden Erfindung sind die Taktdomänen jeweils über Taktmodifizierungselemente wie Phase-Lock-Loops und Delay-Elemente, mit einem Systemtakteingang des Bausteins verbunden, wodurch die Phasen der einzelnen Taktdomänen regelbar sind. So wird eine einfachere und weniger aufwendige Nachbehandlung der Bausteinumgebung und eine größere Übersichtlichkeit vorgesehen. Als Folge sinkt die Wahrscheinlichkeit von Fehleinbauten drastisch bzw. die Transparenz der Schaltungsstruktur steigt.

Gemäß eines anderen vorteilhaften Ausführungsbeispiels der vorliegenden Erfindung sind im Eingabeblock Delayelemente bzw. Verzögerungselemente vor den Input-FF angeordnet, um die Holdzeit bzw. die Haltezeit der Input-FFs abzugleichen.

Gemäß eines weiteren vorteilhaften Ausführungsbeispiels der vorliegenden Erfindung sind im Eingabeblock Delayelemente zum Abgleich des Taktskews nach den Input-FFs und vor dem Restcore angeordnet.

Gemäß eines weiteren Ausführungsbeispiels der vorliegenden Erfindung sind im Ausgabeblock Delayelemente zum Abgleich des Min-Clock-to-Outputs angeordnet.

Vorteilhafterweise können bei den zuletzt genannten Ausführungsbeispielen die Delay-Elemente zum Abgleichen der Hold-Zeit bzw. zum Abgleichen des Min-Clock-to-Output zentral in den Eingabeblock und den Ausgabeblock eingebaut werden.

Ein Ausführungsbeispiel der Erfindung ist in den Zeichnungen dargestellt und wird im folgenden näher beschrieben. Es zeigen:
- Figur 1: einen wie zuvor beschriebenen ASIC gemäß einer herkömmlichen Architektur;
- Figur 2: eine schematische Darstellung eines ASICs gemäß der vorliegenden Erfindung.

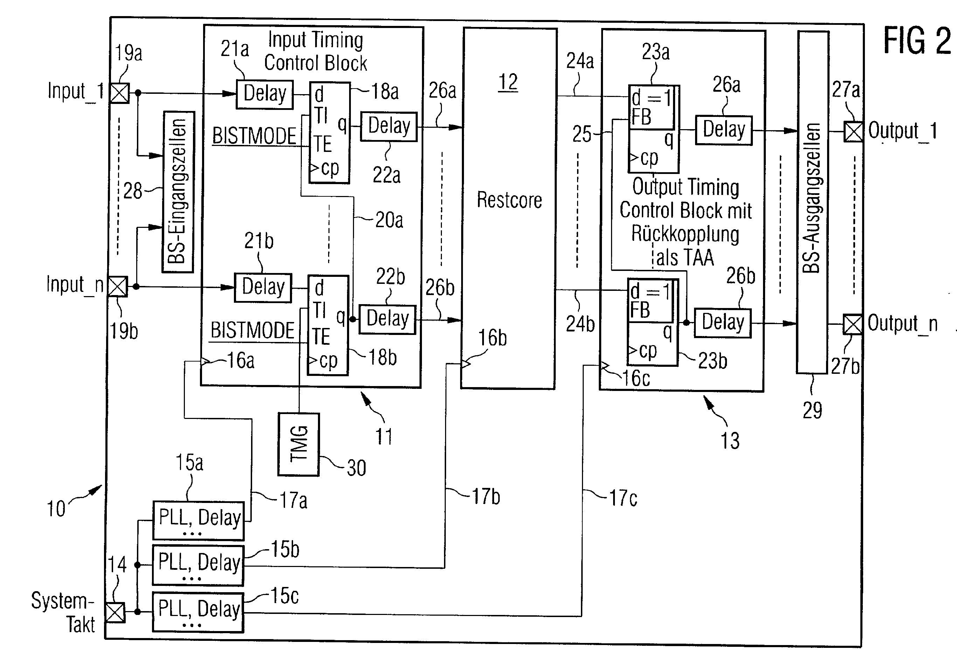

Bezugnehmend auf die Figur 2 wird ein ASIC 10 gemäß der vorliegenden Erfindung beschrieben. Wie aus dem in der Figur 2 dargestellten Blockschaltbild hervorgeht, weist der erfindungsgemäße ASIC 10 zumindest eine Integrierte Schaltung (IC) auf, die im wesentlichen aus drei Blöcken, einem Input-Timing-Control-Block (ITCB) 11 bzw. einen Eingabeblock, einem Restcore 12 und einem Output-Timing-Control-Block (OTCB) bzw. eines Ausgabeblocks 13 aufgebaut ist.

Die drei separaten Blöcke 11, 12 und 13 werden über jeweilige Anschlüsse 16a, 16b und 16c getaktet. Der ASIC 10 erhält an einem Systemtaktanschluss 14 den Systemtakt. Dieser am Systemtaktanschluss 14 erhaltene Systemtakt bzw. Eingangstakt wird über Leitungen 17a, 17b und 17c an die Blöcke 11, 12 und 13 weitergeleitet. Zwischen dem Systemtaktanschluss 14 und den jeweiligen Takteingängen 16a, 16b, und 16c befinden sich Taktmodifizierungselemente 15a, 15b und 15c. Die jeweiligen Taktmodifizierungselemente 15a, 15b und 15c umfassen Delay-Elemente, PLLs oder Delay-Lock-Loops (DLL) und bilden somit für die Blöcke 11, 12 und 13 eine blockspezifische Taktung. Die Blöcke mit der unterschiedlichen Taktung bilden unterschiedliche Taktdomänen im ASIC 10. Im bevorzugten Ausführungsbeispiel unterscheiden sich die Taktdomänen der Blöcke 11, 12 und 13 in ihrer Taktphase. Weiterhin unterscheiden sich im bevorzugten Ausführungsbeispiel die Taktdomänen des Eingabeblocks 11 und des Ausgabeblocks 13 von der des Restcores 12, wobei der Restcore 12 eine vom Systemtakt verschiedene Taktdomäne bildet. Es sind jedoch auch durchaus andere Konstellationen denkbar, z.B. eine, bei der sich wie im vorherigen Beispiel die Taktdomänen des Eingabeblocks 11 und des Ausgabeblocks 13 von der des Restcores 12 unterscheiden, aber der Restcore 12 mit einem unveränderten Systemtakt getaktet wird.

Obwohl das bevorzugte Ausführungsbeispiel der Figur 2 jeweils nur ein ITCB 11 und einen OTCB 13 zeigt, können beide, ITCB 11 und OTCB 13 durchaus mehrfach existieren, wenn das durch zahlreiche Taktdomänen auf Grund der ASIC Anwendung erzwungen wird.

Die Schaltungselemente des ITCB 11, des Rest-Cores 12 und des OTCB 13 gewähren zusammen die Funktion des IC des ASIC 10. Bei den Schaltungselementen handelt es sich um funktionale Flip-Flops (FF) und andere funktionale Elemente wie Inverter, NANDs und NORs, etc. Der Begriff "funktional" bezeichnet im folgenden Flip-Flops oder andere Schaltungselemente, die allein für den Betrieb des ASICS 10 und die Implementierung dessen anwendungsspezifischer Funktion benötigt werden. Solche Flip-Flops oder Schaltungselemente, wie zum Beispiel die eingangs erwähnten BS-Eingangs- und Ausgangszellen 5, 6 zum Testen des ASICs 10, fallen nicht unter diesen Begriff.

Die Blöcke 11, 12 und 13 umfassen zusammen den bezüglich des Standes der Technik beschriebenen ASIC-Core 2 (siehe Figur 1). Der ITCB 11 weist eine Vielzahl von funktionalen Flip-Flops 18 auf, die im folgenden als Input-FFs bezeichnet werden. Die Input-FFs 18 sowie andere im ITCB 11 befindliche Flip-Flops oder Schaltungselemente (nicht dargestellt) sind funktionale Bestandteile des bezüglich des Standes der Technik erwähnten ASIC-Cores 2, die jedoch in den ITCB 11 ausgelagert sind.

Jedes Input-FF 18 ist am Dateninput d über einen Eingangsbuffer (hier nicht dargestellt) mit einem entsprechenden Eingangspin 19 verbunden. Der Ausgang q eines Input-FF 18 ist indirekt, d.h. über andere nicht dargestellte Schaltungskomponenten des ITCB 11, oder direkt mit dem Restcore 12 verbunden. Desweiteren weist jedes Input-FF 18 einen Clock-Eingang CP auf, an dem die blockspezifische Taktung entweder unverändert, so wie im Takteingang 16a des ITCB 11 empfangen, oder in einer blockinternen abgeänderten Form angelegt wird.

Des weiteren weist jedes Input-FF 18a einen Tester-Input-Eingang TI auf, der mit dem Ausgang q eines benachbarten Input-FFs 18b über Leitung 20 verbunden ist. Im Eingangsbereich eines jeden Input-FF 18 befindet sich ein Multiplexer (nicht dargestellt), der die Anschlüsse d und TI als Eingänge hat und je nach seinem Schaltzustand entweder die Eingabe am Anschluß d oder am Anschluß TI an das eigentliche Input-FF 18 weitergibt. Der Multiplexer wird durch ein Steuersignal, das über einen Anschluß des Scann-FF 18, welches als Tester-Eingang TE bezeichnet wird, gesteuert. Die weitere Funktion des Multiplexers wird weiter unten bezüglich des Built-In-Self-Tests (BIST) beschrieben.

Es ist hier anzumerken, daß die gestrichelten Linien in der Figur 2 schematisch für eine beliebige Anzahl der über und unter der gestrichelten Linie befindlichen ASIC-Komponenten steht. Bezüglich des ITCB 11 bedeutet dies, daß eine beliebige Vielzahl von Input-FFs 18 impliziert sind, wobei der Eingang TI eines jeden Input-FFs 18a bei entsprechender Schaltung des Multiplexers des Input-FFs 18a mit dem Ausgang q des benachbarten Input-FFs 18b über eine Leitung 20 verbunden ist.

Im Normalbetrieb erhält der ASIC 10 seine Eingaben bzw. Eingangsgrößen über die Eingangspins 19a, 19b. Die Eingaben werden gleich nach den Input-Puffern (nicht dargestellt) im ITCB 11 mittels der Input-FF 18a, 18b abgetaktet, d.h. die Eingabe wird in das Input-FF 18 übernommen. Bei Bedarf können zur Erfüllung des Pin-Input-Timings erste Delay-Elemente 21a, 21b in den ITCB 11 vor einem jeweiligen Input-FF 18a, 18b eingefügt werden. Auch das Einsetzen von zweiten Delay-Elementen 22a, 22b zwischen dem ITCB 11 und dem Restcore 12 zum Abgleichen des Taktskews ist möglich. Der Taktskew bezeichnet die Bandbreite der Phasenverschiebung der Takte an den Clock-Eingängen CP der Input-FFs 18 innerhalb des ITCB 11.

Die Ausgabedaten des ITCB 11 werden über Leitungen 26a, 26b in den Restcore 12 eingegeben, um dort weiterverarbeitet zu werden. Die Verarbeitung erfolgt im Restcore 12 mit einer am Takteingang 16b angelegten Taktung. Nach der Verarbeitung im Restcore 12 werden die Daten über Leitungen 24a, 24b in den OTCB 13 eingegeben.

Der OTCB 13 umfaßt ähnlich wie der ITCB 11 funktionale Flip-Flops, die im folgenden als Output-FFs 23 bezeichnet werden. Die Output-FFs 23a, 23b, sowie gegebenenfalls andere im OTCB vorhandene Schaltungskomponenten sind funktionelle Bestandteile des ASIC-Cores 10. Nach Eingabe der Ausgaben des Restcore 12 in den OTCB 13 werden die Eingaben entweder indirekt, d.h. über möglicherweise andere vorhandene Schaltungskomponenten des OTCB 13 (nicht dargestellt) oder direkt mittels der Output-FFs 23a, 23b entsprechend abgetaktet. Jeder Output-FF 23a, 23b weist einen Eingang d zum Datenempfang vom Restcore 12 auf sowie einen Eingang FB, der über eine Leitung 25 mit dem Ausgang q eines anderen Output-FFs 23b verbunden ist. Im Eingangsbereich der Output-FFs 23 befindet sich ein XOR-Gatter mit den Eingängen d und FB als Gattereingänge.

Die Taktung der Output-FFs 23 des OTCB 13 erfolgt wiederum über einen Clock-Eingang CP der Output-FFs 23, an dem die blockspezifische Taktung entweder unverändert, so wie im Takteingang 16c des OTCB 12 empfangen, oder in einer blockinternen abgeänderten Form angelegt wird.

Die Ausgabe der Output-FFs 23 wird am Ausgang q vorgesehen. Die Ausgänge q sind über Ausgangsbuffer (hier nicht dargestellt) mit jeweiligen Ausgabepins 27a, 27b verbunden. Zum Abgleichen des Min-clock-tool-outputs können dritte Delay-Elemente 26a, 26b in dem OTCB 13 nach den Output-FFs 23a, 23b vorgesehen werden. Im Normalbetrieb liefert der OTCB 13 somit die ASIC-Ausgaben an die entsprechenden Pins 27.

Im folgenden wird besprochen, wie die eingangs erwähnten Design-for-test (DFT)-Verfahren, der Built-In-Selftest (BIST) und der Boundary Scan (BS) in einer integrierten Schaltung mit der oben beschriebenen Architektur mit mehreren Taktdomänen implementiert wird.

Für den Boundary Scan werden BS-Eingangszellen 28 nach den Input-Pins 19a, 19b und den Eingangspuffern vorgesehen. Die BS-Eingangszellen 28 werden direkt von den ASIC-Input-Puffern (nicht dargestellt) getrieben, da sie parallel zu dem ITCB 11 angeordnet sind. Ebenso werden auf der Ausgabeseite BS-Ausgangszellen 29 nach dem OTCB 13 und vor den Ausgangsbuffern (nicht dargestellt) und den Ausgabepins 27a, 27b vorgesehen. Alle ASIC-Ausgaben werden vor den BS-Ausgangszellen 29 im OTCB 13 abgetaktet. Die BS-Ausgangszellen bzw. Boundary-Scan-Zellen 29 befinden sich, wie nach dem Standard IEEE 1149 gefordert, zwischen den Output-FFs 23a, 23b und den Ausgangspuffern. Somit ist die Unabhängigkeit des Boundary Scans nach IEEE 1149 gewährleistet.

Für den BIST wird der ASIC 10 in den BIST-Modus gebracht. Im ITCB 11 werden im BIST-Modus die Input-FFs 18a, 18b über ein BIST-MODE-Signal am Eingang TE durch Steuern der Multiplexer zu einer Kette zusammengeschaltet. Hierbei wird das erste Input-FF 18b der Kette über den Eingang TI mit einem Testmuster-Generator TMG 30 verbunden. Der Testmuster-Generator 30 speist die Kette von Input-FFs 18a, 18b mit einem Testvektor für die Durchführung des BIST. Die herkömmlichen BIST-Eingangszellen (siehe Figur 1) vor den dem ASIC-Core sind nicht mehr nötig, da die spezielle BIST-Funktionalität der BIST-Eingangszellen 28 von den erwähnten Input-FFs 18a, 18b mit übernommen wird. Auf der Ausgangsseite des ASICs 10 werden im BIST-Modus die Output-FFs 23a, 23b im OTCB 13 zu einem linear rückgekoppelten Schieberegister (linear feedback shift register) (LFSR) zusammengeschaltet und bilden den Testantwort-Auswerter (TAA). Die herkömmlichen BIST-Ausgangszellen nach den Output-FFs 23a, 23b entfallen ebenfalls, da die Output-FFs 23a, 23b im BIST-Modus zu besagtem LFSR zusammengeschaltet werden.

Aufgrund des oben beschriebenen Architekturansatzes gemäß der vorliegenden Erfindung ergeben sich folgende Vorteile:
- Das kritische Input/Output-Timing wird vom Core-Timing isoliert. Damit werden die Input/Output-Timing-Probleme einfacher lokalisierbar, abgrenzbar, sowie beherrschbarer und überschaubarer.
- Die strukturierte Bildung von Taktinseln, wie des ITCB 11 und OTCB 13 (Eingabe- und Ausgabeseitig) mittels Delay-Elementen, PLLs oder DLLs wird einfacher, die Nachbehandlung der Umgebung wird weniger aufwendig und übersichtlicher. Die Wahrscheinlichkeit von Fehleinbauten sinkt drastisch bzw. die Transparenz der Schaltungsstruktur steigt.
- Die Delay-Elemente zum Abgleichen der Hold-Zeit 21a, 21b bzw. zum Abgleichen des min-clock-to-output 26a, 26b können (zentral) in den ITCB 11 und den OTCB 13 eingebaut werden.
- Die BIST-Eingangs- und Ausgangszellen für den BIST entfallen. Die Gatterzahl sinkt daher.
- Nachdem eingangsseitig der BIST-Multiplexer wegfällt, wird das Timing des Signal-Input-Pfades verbessert.
- Ausgangsseitig wird das Timing auch entschärft, da die Abzapfung für die BIST-Ausgangszellen wegfällt.
- Die Anordnung der Zeitkritischen "ersten" bzw. "letzten" Flip-Flops, also der Input-FFs und der Output-FFs im ASIC-Layout wird einfacher, da sich alle im ITCB 11 oder OTCB 13 befinden und diese in der Architektur des erfindungsgemäßen ASICs 10 eine eigene Einheit bilden.
- Die Blöcke ITCB 11 und OTCB 13 können wie die Boundary Scan Blöcke bei herkömmlichen ASICs auf 8 bzw. 16 Unterblöcke aufgeteilt werden. Dadurch ist es im Layout des ASIC 10 möglich, diese Unterblöcke mit den funktionalen Blöcken im Restcore 12 zu mergen, d.h. örtlich nah aneinander anzuordnen, wobei die logische Trennung jedoch erhalten bleibt. Dadurch wird das Timing zwischen dem Rand, d.h. den ITCB 11 und OTCB-Blöcken 11, 13 und dem Restcore 12 entschärft.

Zusammenfassend läßt sich sagen, daß die vorgestellte Architektur der vorliegenden Erfindung es erlaubt, den ASIC hinsichtlich unterschiedlicher Taktdomänen bzw. Taktinseln zu konfigurieren, wobei der BIST miteingeschlossen ist (praktisch abfällt) und die konventionellen BIST-Ein- und Ausgangszellen überflüssig macht, sowie den gemäß Standard 1149 definierten Boundary-Scan mit berücksichtigt. Eine Optimierung des Timings, der Verifikation und der Implementierung der einzelnen Bauelemente wird somit erreicht. Abschließend wird angemerkt, daß obwohl die vorliegende Erfindung bezüglich eines ASIC beschrieben wurde, die vorliegende Erfindung allgemein bei allen integrierten Schaltkreisen angewendet werden kann.

Die vorliegende Erfindung ist insbesondere auch im Zusammenhang mit der am selben Tag hinterlegten Anmeldung ....................... derselben Anmelderin mit dem Titel "Elektronischer Baustein und Verfahren zu dessen Qualifizierungsmessung" einsetzbar, wobei zur Vermeidung von Wiederholungen der Gegenstand dieser Anmeldung auch zum Inhalt der vorliegenden Anmeldung gemacht wird.

## Patentansprüche

1. Elektronischer Baustein (10) mit einer Integrierten Schaltung, die einen Core mit funktionalen Flip-Flops aufweist, wobei ein Teil der funktionalen Flip-Flops als Input-FFs (18) mit Einganspins (19) des Bausteins (10) und ein Teil der funktionalen Flip-Flops als Output-FFs (23) mit Ausgangspins (27) des Bausteins (10) verbunden sind,
**dadurch gekennzeichnet,**
**daß** die Input-FFs (18) und die Output-FFs (23) jeweils mindestens einen Eingabeblock (11) und einen Ausgabeblock (13) mit eigenen Taktdomänen, die sich von der Taktdomäne des Restcores (12) unterscheiden, bilden.

2. Baustein nach Anspruch 1,
**dadurch gekennzeichnet,**
**daß** zur Durchführung eines Boundary Scans (BS) entsprechende BS-Eingangszellen (28), die den Input-FFs (18) parallel vorgelagert sind, außerhalb des Ausgabeblocks (13) und weiter BS-Ausgangszellen (29) nach den Output-FFs (23) außerhalb des Ausgabeblocks (13) vorgesehen sind.

3. Baustein nach Anspruch 1 oder 2,
**dadurch gekennzeichnet,**
**daß** zur Durchführung eines Build-In-Self-Tests (BIST) die Input-FFs (18) des Eingabeblocks (11) zu einer Kette zusammenschaltbar sind, die während des BIST von einem Testmustergenerator (30) mit Testvektoren gespeist wird, und daß die Output-FFs (23) des Ausgabeblocks zu einem Linear-Feedback-Shift-Register zusammenschaltbar sind und einen Testantwortauswerter (TAA) für den BIST bilden.

4. Baustein nach einem der vorhergehenden Ansprüche,
**dadurch gekennzeichnet,**
**daß** die Input-FFs (18) und die Output-FFs (23) jeweils über Eingangsbuffer mit den Einganspins (19) bzw. über Ausgangsbuffer mit den Ausgangspins (27) verbunden sind.

5. Baustein nach einem der vorhergehenden Ansprüche,
**dadurch gekennzeichnet,**
**daß** die Taktphasen der Taktdomänen der Input-FFs (18) und der Output-FFs (23) sich von der Taktphase des verbleibenden Cores (12) unterscheiden.

6. Baustein nach einem der vorhergehenden Ansprüche,
**dadurch gekennzeichnet,**
**daß** die Taktphasen der Taktdomänen der Input-FFs (18) und der Output-FFs (23) sich von der Taktphase einer Systemtaktung (14) des Bausteines (10) unterscheiden.

7. Baustein nach einem der vorhergehenden Ansprüche,
**dadurch gekennzeichnet,**
**daß** die Taktdomänen jeweils über Taktmodifizierungselemente (15) mit einem Systemtakteingang (14) des Bausteins (10) verbunden sind.

8. Baustein nach einem der vorhergehenden Ansprüche,
**dadurch gekennzeichnet,**
**daß** im Eingabeblock (11) erste Delayelemente (21) zum Abgleich der Holdzeit vor den Input-FF (18) angeordnet sind.

9. Baustein nach einem der vorhergehenden Ansprüche,
**dadurch gekennzeichnet,**
**daß** im Eingabeblock (11) zweite Delayelemente (22) zum Abgleich des Taktskews nach den Input-FFs (18) und vor dem Restcore (12) angeordnet sind.

10. Baustein nach einem der vorhergehenden Ansprüche,
**dadurch gekennzeichnet,**
**daß** im Ausgabeblock (13) dritte Delayelemente (26b) zum Abgleich des Min-Clock-to-Outputs angeordnet sind.
